# EUROPÄISCHE PATENTANMELDUNG

(11) **EP 4 787 432 A1**
(43) Veröffentlichungstag der Anmeldung: **05.08.2026**
(21) Anmeldenummer: 25155317.8
(22) Anmeldetag: 31.01.2025
(51) Int. Cl.: H01L 23/00, H01L 23/373

(54) **SUBSTRATANORDNUNG, VERFAHREN ZUR HERSTELLUNG EINER ELEKTRONISCHEN BAUGRUPPE UND ELEKTRONISCHE BAUGRUPPE**

(71) Anmelder: Heraeus Electronics GmbH & Co. KG, 63450 Hanau (DE)
(72) Erfinder: Krüger, Frank, 63450 Hanau (DE); Stoica, Stefanie, 63450 Hanau (DE); Klein, Andreas Steffen, 63450 Hanau (DE)
(74) Vertreter: Heraeus IP

(57) **Zusammenfassung**

Die Erfindung betrifft eine Substratanordnung, ein Verfahren zur Herstellung einer elektronischen Baugruppe und eine elektronische Baugruppe.

Die Substratanordnung weist auf (a) eine Metallfolie, die eine Metallfolienoberseite und eine Metallfolienunterseite umfasst, wobei die Metallfolie eine Kupferschicht umfasst, die eine Kupferschichtoberseite und eine Kupferschichtunterseite aufweist, wobei die Metallfolienoberseite von der Kupferschichtoberseite gebildet ist, und (b) eine Kontaktierungsschicht, die auf der Metallfolienunterseite angeordnet ist, wobei die Kupferschichtoberseite einen Gehalt an Sauerstoff im Bereich von 10 - 30 Atomprozent aufweist.

## Beschreibung

Die vorliegende Erfindung betrifft eine Substratanordnung, ein Verfahren zur Herstellung einer elektronischen Baugruppe und eine elektronische Baugruppe.

Zur Herstellung von elektronischen Baugruppen werden in der Leistungselektronik häufig Grundsubstrate, insbesondere Metall-Keramik-Substrate oder Leadframes, mit Elektronikbauteilen, insbesondere Halbleiterbauelementen, bestückt.

Auf der Oberseite der Elektronikbauteile, die den Grundsubstraten abgewandt ist, befinden sich Bereiche, die mit unbestückten Bereichen der Grundsubstrate elektrisch leitend kontaktiert werden müssen. Diese Kontaktierung erfolgt üblicherweise mit Bonddrähten, wobei ein Ende des Bonddrahts stoffschlüssig mit einem Bereich auf der Oberseite des Elektronikbauteils verbunden wird, während das andere Ende des Bonddrahts stoffschlüssig mit einem unbestückten Bereich des Grundsubstrats verbunden wird. Bonddrähte aus Aluminium können mit dem Metall der Grundsubstrate, insbesondere Kupfer, stoffschlüssig verbunden werden. Auch mit den Elektronikbauteilen lassen sich Bonddrähte aus Aluminium, zum Beispiel über eine metallische, zumeist silberhaltige Schicht, die sich auf der Oberseite der Elektronikbauteile befindet, stoffschlüssig verbinden. Bonddrähte aus Aluminium weisen allerdings den Nachteil einer geringen elektrischen Leitfähigkeit auf. Ferner hat sich herausgestellt, dass eine elektrische Kontaktierung von Elektronikbauteilen und Grundsubstraten über Bonddrähte aus Aluminium eine nur unzureichende Zuverlässigkeit und verminderte Funktionsfähigkeit aufweisen.

Aus diesem Grund gibt es den Bedarf, Bonddrähte aus Aluminium durch Bonddrähte aus Kupfer zu ersetzen. Kupfer weist im Vergleich zu Aluminium eine sehr hohe elektrische Leitfähigkeit auf. Darüber hinaus lassen sich Bonddrähte aus Kupfer mit dem Metall der Grundsubstrate, insbesondere Kupfer, besonders zuverlässig stoffschlüssig verbinden. Allerdings können Bonddrähte aus Kupfer nicht ohne weiteres stoffschlüssig mit der Oberseite der Elektronikbauteile verbunden werden.

Im Stand der Technik wird daher vorgeschlagen, Bonddrähte aus Kupfer nicht direkt mit der Oberseite der Elektronikbauteile zu verbinden. Vielmehr wird eine Substratanordnung bereitgestellt, die eine Metallfolie und eine Kontaktierungsschicht (zum Beispiel eine vorgetrocknete Sinterpaste) aufweist. Die Metallfolie, weist eine Oberseite und eine Unterseite auf, wobei die Unterseite der Metallfolie mit der Kontaktierungsschicht flächig verbunden ist. Die Metallfolie der Substratanordnung wird schließlich über die Kontaktierungsschicht mit der Oberseite des Elektronikbauteils stoffschlüssig verbunden, so dass die Oberseite der Metallfolie für eine stoffschlüssige Verbindung mit dem Kupferbonddraht zur Verfügung steht.

Es besteht daher Bedarf an einer Substratanordnung mit einer Metallfolie, deren Oberseite mit einem Kupferbonddraht besonders stabil und mit gleichmäßig hoher Qualität verbindbar ist.

Daher besteht eine Aufgabe der vorliegenden Erfindung vorzugsweise darin, eine Substratanordnung mit einer Metallfolie bereitzustellen, deren Oberseite mit einem Kupferbonddraht besonders stabil und mit gleichmäßig hoher Qualität verbindbar ist.

Diese Aufgabe wird gelöst durch die Substratanordnung gemäß Anspruch 1.

Die Erfindung stellt daher eine Substratanordnung bereit, aufweisend
(a) eine Metallfolie, die eine Metallfolienoberseite und eine Metallfolienunterseite umfasst, wobei die Metallfolie eine Kupferschicht umfasst, die eine Kupferschichtoberseite und eine Kupferschichtunterseite aufweist, wobei die Metallfolienoberseite von der Kupferschichtoberseite gebildet ist, und
(b) eine Kontaktierungsschicht, die auf der Metallfolienunterseite angeordnet ist,
dadurch gekennzeichnet, dass die Kupferschichtoberseite einen Gehalt an Sauerstoff im Bereich von 10 - 30 Atomprozent aufweist.

Ferner stellt die Erfindung ein Verfahren zur Herstellung einer elektronischen Baugruppe und eine elektronische Baugruppe bereit.

Die Erfindung betrifft eine Substratanordnung.

Mit der Substratanordnung kann vorzugsweise die elektrische Kontaktierung der Oberseite eines Elektronikbauteils mit unbestückten Bereichen von Grundsubstraten vorbereitet werden. Hierzu wird die Metallfolie über die Kontaktierungsschicht mit der Oberseite des Elektronikbauteils stoffschlüssig verbunden. Die Metallfolie stellt dabei eine Oberfläche bereit, die für die Ausbildung einer zuverlässigen stoffschlüssigen Verbindung mit einem Ende eines Bonddrahtes, insbesondere eines Kupferbonddrahtes, geeignet ist. Das andere Ende des Bonddrahtes kann mit einem unbestückten Bereich eines Grundsubstrats verbunden werden, so dass eine elektrische Kontaktierung zwischen der Oberseite des Elektronikbauteils und einem unbestückten Bereich eines Grundsubstrats über die Metallfolie und den Bonddraht resultiert.

Die Substratanordnung weist eine Metallfolie auf.

Die Metallfolie umfasst eine Metallfolienoberseite und eine Metallfolienunterseite. Auf der Metallfolienunterseite ist eine Kontaktierungsschicht angeordnet. Dabei ist die Metallfolienunterseite mit der Kontaktierungsschicht vorzugsweise wenigstens bereichsweise flächig verbunden. Die Metallfolienunterseite ist daher vorzugsweise die Fläche der Metallfolie mit dem größten Flächeninhalt, die mit der Kontaktierungsschicht wenigstens bereichsweise flächig verbunden ist. Daher ist die Metallfolienoberseite vorzugsweise die der Kontaktierungsschicht abgewandte Seite der Metallfolie. Die Metallfolienoberseite ist folglich die der Metallfolienunterseite gegenüberliegende Seite.

Gemäß einer bevorzugten Ausführungsform ist die Metallfolienoberseite nicht stoffschlüssig mit einem Festkörper verbunden. Ein Festkörper ist vorzugsweise ein Körper, der bei einer Temperatur von 25°C und Normaldruck fest ist. Vorzugsweise ist die Metallfolienoberseite nicht stoffschlüssig mit einer Schicht aus isolierendem Material verbunden. Besonders bevorzugt ist die Metallfolienoberseite nicht stoffschlüssig mit einer Keramikschicht verbunden.

Gemäß einer weiteren bevorzugten Ausführungsform sind weniger als 20 Prozent, mehr bevorzugt weniger als 10 Prozent, noch mehr bevorzugt weniger als 5 Prozent, ganz besonders bevorzugt weniger als 1 Prozent und insbesondere weniger als 0,1 Prozent der Metallfolienoberseite, bezogen auf die Gesamtfläche der Metallfolienoberseite, mit einem Festkörper unlösbar verbunden. Unlösbar verbunden bedeutet vorzugsweise, dass eine Lösung der Verbindung nicht möglich ist oder eine wenigstens teilweise Zerstörung der Metallfolienoberseite, zumindest aber eine Funktionsbeeinträchtigung, zur Folge hätte. Bei dem Festkörper kann es sich um einen Festkörper umfassend isolierendes Material, insbesondere um einen Keramikkörper, handeln.

Gemäß einer weiteren bevorzugten Ausführungsform ist die Metallfolienoberseite mit einem Bonddraht, vorzugsweise einem Bonddraht, der wenigstens 50 Gewichtsprozent Kupfer umfasst, verbindbar.

Die Metallfolie weist vorzugsweise eine Dicke d(Me) auf. Die Dicke d(Me) der Metallfolie liegt vorzugsweise im Bereich von 5 - 500 µm, besonders bevorzugt im Bereich von 10 - 200 µm und ganz besonders bevorzugt im Bereich von 20 - 150 µm.

Die Metallfolie umfasst eine Kupferschicht.

Die Kupferschicht ist vorzugsweise von einer Kupferfolie gebildet. Die Kupferschicht weist vorzugsweise wenigstens 99,5 Gewichtsprozent Kupfer, besonders bevorzugt wenigstens 99,95 Gewichtsprozent Kupfer und ganz besonders bevorzugt wenigstens 99,995 Gewichtsprozent Kupfer, bezogen auf das Gesamtgewicht der Kupferschicht, auf.

Die Kupferschicht weist eine Kupferschichtoberseite und eine Kupferschichtunterseite auf. Die Metallfolienoberseite ist von der Kupferschichtoberseite gebildet. Die Kupferschichtunterseite kann mit einer weiteren Schicht verbunden sein.

Die Metallfolie kann aus der Kupferschicht bestehen. In diesem Fall kann die Metallfolienunterseite von der Kupferschichtunterseite gebildet sein.

Die Kupferschichtoberseite weist einen Gehalt an Sauerstoff im Bereich von 10 - 30 Atomprozent auf. Die Kupferschichtoberseite weist vorzugsweise einen Gehalt an Sauerstoff im Bereich von 12 - 28 Atomprozent und besonders bevorzugt einen Gehalt an Sauerstoff im Bereich von 15 - 25 Atomprozent auf.

Gemäß einer bevorzugten Ausführungsform weist die Kupferschichtoberseite einen Gehalt an Kohlenstoff im Bereich von 30 - 60 Atomprozent auf. Die Kupferschichtoberseite weist vorzugsweise einen Gehalt an Kohlenstoff im Bereich von 35 - 55 Atomprozent und besonders bevorzugt einen Gehalt an Kohlenstoff im Bereich von 40 - 50 Atomprozent auf.

Gemäß einer bevorzugten Ausführungsform ist die Kupferschichtoberseite so beschaffen, dass bei einer Tiefenprofilmessung nach Absputtern für eine Sputterzeit von 300 s (Sputterrate: 1,0 nm/min für Referenz Tantalpentoxid; lonenquelle: Xenon-Ionen, Beschleunigungsspannung: 4 kV) die freigelegte Kupferschichtoberseite einen Gehalt an Sauerstoff von weniger als 1,0 Atomprozent aufweist.

Gemäß einer weiteren bevorzugten Ausführungsform ist die Kupferschichtoberseite so beschaffen, dass dass bei einer Tiefenprofilmessung nach Absputtern für eine Sputterzeit von 180 s (Sputterrate: 1,0 nm/min für Referenz Tantalpentoxid; lonenquelle: Xenon-Ionen, Beschleunigungsspannung: 4 kV) die freigelegte Kupferschichtoberseite einen Gehalt an Sauerstoff von weniger als 1,0 Atomprozent aufweist.

Der Gehalt der Kupferschichtoberseite an Kupfer, Kohlenstoff und Sauerstoff wird vorzugsweise mittels Auger-Elektronenspektroskopie bestimmt. Die Messung erfolgt vorzugsweise mit dem PHI 5800 MultiTechnique ESCA System (Physical Electronics, Inc., USA). Die zu vermessende Probe der Substratanordnung wird vorzugsweise zunächst in einem Feuchtigkeitsbarrierebeutel unter Stickstoffatmosphäre gelagert. Dazu wird die Probe nach der Probennahme in den Feuchtigkeitsbarrierebeutel überführt und mit Stickstoff mit einer Reinheit von 4 N zweimal gespült. Danach wird der Beutel durch Verschweißen verschlossen. Der Feuchtigkeitsbarrierebeutel wird unmittelbar vor der Messung geöffnet und die dort enthaltene Probe wird sodann in die Messkammer des PHI 5800 MultiTechnique ESCA System eingebracht. In der Messkammer erfolgt die Messung des Gehalts der Kupferschichtoberseite an Kupfer, Kohlenstoff und Sauerstoff mittels Auger-Elektronenspektroskopie. Für die Tiefenprofilmessung wird ebenfalls vorzugsweise das PHI 5800 MultiTechnique ESCA System verwendet. Hierzu wird die Kupferschichtoberseite der Probe für eine festgelegte Zeit (zum Beispiel 300 s oder 180 s) besputtert und der Gehalt der durch Absputtern freigelegten Kupferschichtoberseite an Kupfer, Kohlenstoff und Sauerstoff mittels Auger-Elektronenspektroskopie gemessen. Das Sputtern erfolgt vorzugsweise mit einer Ionen-Kanone (mit Xenon-Ionen als lonenquelle), die mit einer Beschleunigungsspannung von 4 kV bei einer Sputterrate von 1,0 nm/min gegen die Referenz Tantalpentoxid betrieben wird. Die Analyseparameter für die Auger-Elektronenspektroskopie sind vorzugsweise 5 kV bei einem Strahlstrom von 15 nA und einem Messfleck von 100 x100 µm. Die Auswertung der mittels Auger-Elektronenspektroskopie erhaltenen Signale erfolgt vorzugsweise mit der Software: PHI MultiPak Version 9.9 (Physical Electronics, Inc., USA). Die angegebenen Werte sind vorzugsweise Mittelwerte aus fünf Messungen an unterschiedlichen Bereichen der Substratanordnung.

Gemäß einer bevorzugten Ausführungsform umfasst die Metallfolie eine Haftvermittlungsschicht.

Die Haftvermittlungsschicht ist vorzugsweise eine Schicht, die eine Haftung der Kontaktierungsschicht auf der Metallfolienunterseite ermöglicht oder fördert. Die Haftvermittlungsschicht ist vorzugsweise eine Schicht, die die Ausbildung einer stoffschlüssigen Verbindung zwischen der Substratanordnung (insbesondere der Metallfolienunterseite der Substratanordnung) und der Oberseite eines Elektronikbauteils über die Kontaktierungsschicht ermöglicht oder fördert.

Die Haftvermittlungsschicht weist vorzugsweise eine Dicke im Bereich von 20 - 1500 nm, besonders bevorzugt eine Dicke im Bereich von 30 - 100 nm und ganz besonders bevorzugt eine Dicke im Bereich von 50 - 500 nm auf.

Die Haftvermittlungsschicht weist vorzugsweise eine Haftvermittlungsschichtoberseite und eine Haftvermittlungsschichtunterseite auf. Die Haftvermittlungsschichtoberseite ist vorzugsweise mit der Kupferschichtunterseite stoffschlüssig verbunden. Dabei ist die Haftvermittlungsschichtoberseite mit der Kupferschichtunterseite vorzugsweise flächig verbunden. Vorzugsweise ist die Kontaktierungsschicht auf der Haftvermittlungsschichtunterseite angeordnet.

Die Haftvermittlungsschicht umfasst vorzugsweise ein Edelmetall oder eine Edelmetalllegierung. Das Edelmetall ist vorzugsweise aus der Gruppe ausgewählt, die aus Gold, Silber und Palladium besteht. Die Edelmetalllegierung ist vorzugsweise eine Legierung, die wenigstens ein Edelmetall und wenigstens ein Nichtedelmetall enthält. Das Edelmetall der Edelmetalllegierung ist dabei vorzugsweise aus der Gruppe ausgewählt, die aus Gold, Silber und Palladium besteht. Das Nichtedelmetall der Edelmetalllegierung ist vorzugsweise Nickel. Die Edelmetalllegierung ist vorzugsweise aus der Gruppe ausgewählt, die aus Nickel-Gold-Legierungen, Nickel-Silber-Legierungen und Nickel-Palladium-Gold-Legierungen besteht.

Gemäß einer besonders bevorzugten Ausführungsform ist die Haftvermittlungsschicht mehrlagig ausgestaltet. Eine mehrlagige Ausgestaltung sieht zum Beispiel eine Nickellage, die mit der Kupferschichtunterseite in Kontakt steht, eine mit der Nickellage in Kontakt stehende Palladiumlage und eine mit der Palladiumlage in Kontakt stehende Goldlage vor.

Die Haftvermittlungsschicht kann zum Beispiel durch chemische (zum Beispiel elektrochemische) oder physikalische Abscheidung, insbesondere auf der Kupferschichtunterseite, geschaffen sein. Die chemische Abscheidung kann zum Beispiel galvanisch oder außenstromlos erfolgen.

Gemäß einer weiteren bevorzugten Ausführungsform weist die Metallfolie wenigstens eine Durchgangsöffnung auf. Unter Durchgangsöffnung ist vorzugsweise eine Ausnehmung im Material der Metallfolie zu verstehen, die sich von einer ersten Öffnung auf der Metallfolienoberseite bis zu einer zweiten Öffnung auf der Metallfolienunterseite erstreckt. Die Öffnungen können dabei unterschiedliche Größen und Geometrien aufweisen. Es kann bevorzugt sein, dass die Metallfolie mehrere Durchgangsöffnungen aufweist. Die Durchgangsöffnungen können beispielsweise zylindrisch, rund, rechteckig, oval, elliptisch oder rechteckig mit abgerundeten Ecken ausgestaltet sein. Die Gegenwart von Durchgangsöffnungen kann insbesondere dann vorteilhaft sein, wenn die Substratanordnung eine Vorfixierschicht umfasst, die ein Vorfixiermittel enthält. In diesem Fall können sich Anteile oder Reste des Vorfixiermittels bei einer Temperaturbeaufschlagung oder Druckbeaufschlagung, wie zum Beispiel bei einem Sintervorgang, verflüssigen und in die Durchgangsöffnungen aufgrund der durch die Durchgangsöffnung hervorgerufenen Kapillarwirkung aufgenommen werden, um dadurch ein unkontrollierbares Austreten der Anteile oder Reste des Vorfixiermittels zu vermeiden.

Die Substratanordnung weist eine Kontaktierungsschicht auf.

Die Kontaktierungsschicht ist vorzugsweise eine Schicht, die in der Lage ist, die Ausbildung einer stoffschlüssigen Verbindung zwischen der Oberseite eines Elektronikbauteils, insbesondere der gegebenenfalls metallisierten Oberseite eines Elektronikbauteils, und der Metallfolie, insbesondere der Metallfolienunterseite, zu ermöglichen oder zu befördern.

Die Kontaktierungsschicht ist auf der Metallfolienunterseite angeordnet. Vorzugsweise ist die Kontaktierungsschicht mit der Metallfolienunterseite flächig verbunden.

Die Kontaktierungsschicht weist vorzugsweise eine Dicke im Bereich von 5 - 500 µm, besonders bevorzugt eine Dicke im Bereich von 5 - 250 µm und ganz besonders bevorzugt eine Dicke im Bereich von 10 - 100 µm auf.

Die Kontaktierungsschicht umfasst ein Kontaktierungsmittel. Das Kontaktierungsmittel ist vorzugsweise in der Lage, mit der (gegebenenfalls metallisierten) Oberseite eines Elektronikbauteils eine stoffschlüssige Verbindung einzugehen.

Das Kontaktierungsmittel umfasst vorzugsweise wenigstens ein Mitglied, das aus der Gruppe ausgewählt ist, die aus Silber und Kupfer besteht.

Gemäß einer bevorzugten Ausführungsform umfasst das Kontaktierungsmittel wenigstens ein Element, das aus der Gruppe ausgewählt ist, die aus Sintermaterialien, Lotmaterialien und Klebstoffen besteht.

Das Sintermaterial ist vorzugsweise aus der Gruppe ausgewählt, die aus Sinterpasten, Sinterfolien und Sintervorformen besteht.

Gemäß einer bevorzugten Ausführungsform umfasst das Sintermaterial eine Sinterpaste. Bei der Sinterpaste handelt es sich vorzugsweise um eine fachübliche Sinterpaste. Vorzugsweise umfasst die Sinterpaste wenigstens ein Metall, das aus der Gruppe ausgewählt ist, die aus Silber und Kupfer besteht, und eine organische Verbindung. Es kann bevorzugt sein, dass das Metall in der Sinterpaste in Form von Partikeln vorliegt. Die Partikel können eine beliebige Form annehmen und daher beispielsweise als sphärische Partikel, Flakes oder unregelmäßig geformte Silberpartikel vorliegen. Die organische Verbindung ist vorzugsweise aus der Gruppe ausgewählt, die aus Dispersionsmitteln, Bindemitteln, Fettsäuren und Mischungen davon besteht. Die Dispersionsmittel können aus fachüblichen Dispersionsmitteln ausgewählt sein. Ein beispielhaftes Dispersionsmittel ist Terpineol. Die Bindemittel können aus fachüblichen Polymeren ausgewählt sein. Beispielhaft genannt seien Zellulosederivate, so zum Beispiel Methylzellulose, Ethylzellulose, Ethylmethylzellulose, Carboxyzellullose und Hydroxypropylzellullose. Die Fettsäuren können aus fachüblichen Fettsäuren ausgewählt sein. Vorzugsweise sind die Fettsäuren aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure) und Lignocerinsäure (Tetracosansäure) besteht.

Gemäß einer weiteren bevorzugten Ausführungsform umfasst das Sintermaterial eine Sinterfolie. Vorzugsweise handelt es sich bei der Sinterfolie um eine fachübliche Sinterfolie, wie sie zum Beispiel in der europäischen Patentanmeldung EP3154729 A1 offenbart ist. Eine Sinterfolie kann daher zum Beispiel eine Sinterpaste, die Metallpartikel (insbesondere Silberpartikel) und ein Bindemittel umfasst, aufweisen, die auf einem Trägersubstrat vorgetrocknet vorliegt. Die Sinterfolie kann zum Beispiel eine Dicke im Bereich von 5 - 300 µm aufweisen.

Gemäß einer weiteren bevorzugten Ausführungsform umfasst das Sintermaterial eine Sintervorform. Vorzugsweise handelt es sich bei der Sintervorform um eine fachübliche Sintervorform, wie sie zum Beispiel in der europäischen Patentanmeldung EP2428293 A2 offenbart ist.

Gemäß einer bevorzugten Ausführungsform umfasst das Lotmaterial eine Lotpaste. Bei der Lotpaste handelt es sich vorzugsweise um eine fachübliche Lotpaste. Die Lotpaste umfasst vorzugsweise eine Lotlegierung und ein Flussmittel. Die Lotlegierung umfasst vorzugsweise als Hauptelement (Element mit dem größten Gewichtsanteil) Zinn, besonders bevorzugt wenigstens ein weiteres Element, das aus der Gruppe ausgewählt ist, die aus Kupfer und Silber besteht, und ganz besonders bevorzugt wenigstens ein weiteres Element, das aus der Gruppe ausgewählt ist, die aus Bismut, Antimon, Indium, Germanium, Cobalt, Eisen und Nickel besteht. Das Flussmittel ist vorzugsweise ein fachübliches Flussmittel, besonders bevorzugt ein organisches Flussmittel.

Gemäß einer bevorzugten Ausführungsform umfasst der Klebstoff einen Leitkleber. Beim Leitkleber handelt es sich vorzugsweise um einen fachüblichen Leitkleber. Der Leitkleber umfasst vorzugsweise Silberpartikel und ein Epoxidharz, das besonders bevorzugt bei einer Temperatur im Bereich von 120°C - 200°C aushärtet.

Gemäß einer besonders bevorzugten Ausführungsform umfasst die Kontaktierungsschicht eine vorgetrocknete Sinterpaste.

Gemäß einer bevorzugten Ausführungsform umfasst die Substratanordnung eine Vorfixierschicht.

Die Vorfixierschicht ist vorzugsweise eine Schicht, die mit der Metallfolienunterseite und/oder der Kontaktierungsschicht verbunden ist. Die Metallfolienunterseite ist dabei vorzugsweise durch die Kupferfolienunterseite oder die Haftvermittlungsschicht gebildet. Bei der Vorfixierschicht kann es sich zum Beispiel um eine zusammenhängende Schicht oder um eine unterbrochene Schicht handeln. Die Dimension der zusammenhängenden Schicht ist nicht weiter eingeschränkt. Daher umfasst die zusammenhängende Schicht auch eine punktförmige Schicht. Im Fall einer zusammenhängenden Schicht kann die Vorfixierschicht mit der Metallfolienunterseite und/oder der Kontaktierungsschicht flächig verbunden sein. Im Fall einer unterbrochenen Schicht kann die Vorfixierschicht mehrere, zum Beispiel auch nicht miteinander in Kontakt stehende Abschnitte umfassen, die mit der Metallfolienunterseite und/oder der Kontaktierungsschicht flächig verbunden sind. Sofern die Vorfixierschicht mit der Metallfolienunterseite verbunden ist, ist die Kontaktierungsschicht mit der Metallfolienunterseite vorzugsweise bereichsweise flächig verbunden und die Vorfixierschicht ist mit Bereichen der Metallfolienunterseite verbunden, die nicht flächig mit der Kontaktierungsschicht verbunden sind. Dabei sind die Kontaktierungsschicht und die Vorfixierschicht jeweils mit der Metallfolienunterseite verbunden und vorzugsweise nebeneinander angeordnet.

Gemäß einer bevorzugten Ausführungsform ist die Vorfixierschicht als zusammenhängende Schicht ausgebildet und mit der Kontaktierungsschicht flächig verbunden, so dass wenigstens 20%, mehr bevorzugt wenigstens 50%, besonders bevorzugt wenigstens 70%, ganz besonders bevorzugt wenigstens 98% und insbesondere 100% der Kontaktierungsschicht mit der Vorfixierschicht in Kontakt stehen.

Gemäß einer weiteren bevorzugten Ausführungsform ist die Vorfixierschicht als zusammenhängende Schicht punktförmig ausgebildet und steht mit der Kontaktierungsschicht und/oder mit der Metallfolienunterseite in Kontakt.

Gemäß einer weiteren bevorzugten Ausführungsform ist die Vorfixierschicht als unterbrochene Schicht umfassend mehrere nicht miteinander in Kontakt stehende Abschnitte ausgebildet, die mit der Kontaktierungsschicht und/oder mit der Metallfolienunterseite in Kontakt stehen.

Die Vorfixierschicht umfasst vorzugsweise ein Vorfixiermittel. Das Vorfixiermittel kann zu einer Vorfixierung der Substratanordnung an einem Elektronikbauteil dienen, damit der Aufbau umfassend die Substratanordnung und das Elektronikbauteil eine verbesserte Transportfähigkeit - zum Beispiel zum Ort der Weiterverarbeitung - aufweist. Vorzugsweise ist das Vorfixiermittel ein temporäres oder lösbares Fixiermittel, das zumindest eine vorübergehende Fixierung der Substratanordnung mit einem Elektronikbauteil ermöglicht. Geeignete Vorfixiermittel sind zum Beispiel in der europäischen Patentanmeldung EP3940758 A2 beschrieben.

Das Vorfixiermittel umfasst daher vorzugsweise wenigstens eine Verbindung, die aus der Gruppe ausgewählt ist, die aus thermoplastischen Polymeren, anorganischen Füllstoffpartikeln und organischen Lösungsmitteln besteht. Gemäß einer bevorzugten Ausführungsform umfasst das Vorfixiermittel wenigstens ein thermoplastisches Polymer und besonders bevorzugt wenigstens eine Verbindung, die aus der Gruppe ausgewählt ist, die aus anorganischen Füllstoffpartikeln und organischen Lösungsmitteln besteht.

Die thermoplastischen Polymere weisen vorzugsweise eine Glasübergangstemperatur im Bereich von 60 - 120 °C auf. Die Bestimmung der Glasübergangstemperatur wird vorzugsweise mittels Dynamischer Differenzkalorimetrie (DKK) oder mittels Differential Scanning Calorimetry (DSC) bei einer Aufheizrate von 10 °C/Minute durchgeführt. Bei den thermoplastischen Polymeren kann es sich insbesondere um (Meth)acrylcopolymere handeln. Die (Meth)acrylcopolymere weisen vorzugsweise eine Molmasse im Bereich von 35.000 - 70.000 g/mol auf (Mw = 35.000 bis 70.000 g/mol). Die Molmasse wird vorzugsweise mittels Gelpermeationschromatographie (GPC) bestimmt. Für die Gelpermeationschromatographie gilt: Polystyrolgel als stationäre Phase, Tetrahydrofuran als mobile Phase, Polystyrolstandards.

Die anorganischen Füllstoffpartikel sind vorzugsweise Partikel umfassend wenigstens ein Element, das aus der Gruppe ausgewählt ist, die aus Aluminiumoxid, Siliziumdioxid, Titandioxid, Zirkonsilikat, Calciumsilikat, Glimmer, Kaolin und α-Bornitrid besteht. Vorzugsweise weisen die anorganischen Füllstoffpartikel eine durchschnittliche Teilchengröße (d50) im Bereich von 5 - 20 µm und besonders bevorzugt im Bereich von 5 - 10 µm auf. Die Bestimmung der durchschnittlichen Teilchengröße (d50) erfolgt vorzugsweise mittels eines Laserbeugungsverfahrens.

Die organischen Lösungsmittel weisen vorzugsweise einen Siedepunkt von nicht mehr als 285°C auf. Gemäß einer bevorzugten Ausführungsform sind die organischen Lösungsmittel aus der Gruppe ausgewählt, die aus Aromaten, Ketonen, Estern, Glykolethern und Alkoholen besteht. Gemäß einer besonders bevorzugten Ausführungsform sind die organischen Lösungsmittel aus der Gruppe ausgewählt, die aus Toluol, Xylol, Methylethylketon, Methylisobutylketon, Polyvinylethern, Ethylacetat, Isobutylacetat, Bernsteinsäuredimethylester, Diethylenglykolmonobutylether, Benzylalkohol, Triphenylverbindungen, Dimethylverbindungen und Terpineolen besteht. Gemäß einer ganz besonders bevorzugten Ausführungsform sind die organischen Lösungsmittel aus der Gruppe der Terpineole ausgewählt.

Gemäß einer bevorzugten Ausführungsform ist die Substratanordnung zur Verbindung mit wenigstens einem Elektronikbauteil geeignet. Gemäß einer besonders bevorzugten Ausführungsform ist die Substratanordnung zur Verbindung der Metallfolie mit wenigstens einem Elektronikbauteil geeignet.

Unter Elektronikbauteil wird vorzugsweise ein elektronisches oder elektrisches Bauelement verstanden. Das Elektronikbauteil ist vorzugsweise aus der Gruppe ausgewählt, die aus Halbleiterbauelementen besteht. Die Halbleiterbauelementen sind vorzugsweise aus der Gruppe ausgewählt, die aus Transistoren, Dioden und integrierten Schaltkreisen besteht.

Gemäß einer bevorzugten Ausführungsform umfasst das Elektronikbauteil eine metallische Oberseitenbeschichtung. Die metallische Oberseitenbeschichtung kann dazu dienen, eine leichtere Anbindung der Metallfolie über die Kontaktierungsschicht an die Oberseite des Elektronikbauteils zu ermöglichen. Daher kann es bevorzugt sein, dass die Oberseite des Elektronikbauteils von der metallischen Oberseitenbeschichtung geschaffen wird. Vorzugsweise umfasst die metallische Oberseitenbeschichtung des Elektronikbauteils wenigstens ein Element, das aus der Gruppe ausgewählt ist, die aus Nickel, Palladium, Silber, Kupfer und Gold besteht. Gemäß einer bevorzugten Ausführungsform umfasst das Elektronikbauteil eine metallische Unterseitenbeschichtung. Die metallische Unterseitenbeschichtung kann dazu dienen, eine leichtere Anbindung des Grundsubstrats an die Unterseite des Elektronikbauteils zu ermöglichen. Daher kann es bevorzugt sein, dass die Unterseite des Elektronikbauteils von der metallischen Unterseitenbeschichtung geschaffen wird. Vorzugsweise umfasst die metallische Unterseitenbeschichtung des Elektronikbauteils wenigstens ein Edelmetall. Gemäß einer bevorzugten Ausführungsform umfasst die metallische Unterseitenbeschichtung des Elektronikbauteils wenigstens ein Element, das aus der Gruppe ausgewählt ist, die aus Gold, Silber, Aluminium, Titan und Nickel besteht, und ganz besonders bevorzugt Silber.

Mit der Substratanordnung kann vorzugsweise die elektrische Kontaktierung der Oberseite des Elektronikbauteils mit unbestückten Bereichen von Grundsubstraten vorbereitet werden. Hierzu wird die Metallfolie der Substratanordnung über die Kontaktierungsschicht mit der Oberseite des Elektronikbauteils stoffschlüssig verbunden. Die Metallfolie stellt dabei eine Oberfläche bereit, die für die stoffschlüssige Verbindung mit einem Bonddraht, insbesondere einem Kupferbonddraht, auf besonders stabile Weise und mit gleichmäßig hoher Qualität geeignet ist.

Überraschenderweise hat sich herausgestellt, dass die Oberseite der Metallfolie der Substratanordnung mit einem Kupferbonddraht besonders stabil und mit gleichmäßig hoher Qualität verbindbar ist, wenn die Metallfolie eine Kupferschicht mit einer Kupferschichtoberseite umfasst, die einen Gehalt an Sauerstoff im Bereich von 10 - 30 Atomprozent aufweist. Ohne an eine Erklärung gebunden sein zu wollen, könnte dieser Effekt darauf zurückzuführen sein, dass ein Sauerstoffgehalt in diesem Bereich die unkontrollierte Bildung von dickeren Kupferoxidschichten, die die Bondbarkeit beeinträchtigen könnten, verhindert. Bei einem geringeren Sauerstoffgehalt als 10 Atomprozent könnte diese Wirkung als Schutzschicht nicht mehr in ausreichendem Maße erreicht werden. Bei einem höheren Sauerstoffgehalt als 30 Atomprozent könnte dagegen bereits eine dicke Kupferoxidschicht gebildet sein, die die Bondbarkeit beeinträchtigt.

Das Verfahren zur Herstellung der erfindungsgemäßen Substratanordnung ist nicht weiter eingeschränkt.

Gemäß einer bevorzugten Ausführungsform umfasst das Verfahren zur Herstellung der erfindungsgemäßen Substratanordnung die Schritte:
(A) Bereitstellen einer Metallfolie, die eine Metallfolienoberseite und eine Metallfolienunterseite umfasst, wobei die Metallfolie eine Kupferschicht umfasst, die eine Kupferschichtoberseite und eine Kupferschichtunterseite aufweist, wobei die Metallfolienoberseite von der Kupferschichtoberseite gebildet ist, und wobei die Kupferschichtoberseite einen Gehalt an Sauerstoff im Bereich von 10 - 30 Atomprozent aufweist,
(B) Bereitstellung eines Kontaktierungsmittels und
(C) Aufbringen des Kontaktierungsmittels auf der Metallfolienunterseite unter Ausbildung einer Kontaktierungsschicht.

In Schritt (A) des Verfahrens wird eine Metallfolie bereitgestellt, die eine Metallfolienoberseite und eine Metallfolienunterseite umfasst, wobei die Metallfolie eine Kupferschicht umfasst, die eine Kupferschichtoberseite und eine Kupferschichtunterseite aufweist, wobei die Metallfolienoberseite von der Kupferschichtoberseite gebildet ist, und wobei die Kupferschichtoberseite einen Gehalt an Sauerstoff im Bereich von 10 - 30 Atomprozent aufweist.

Bei der Metallfolie handelt es sich vorzugsweise um eine wie hierin an anderer Stelle beschriebene Metallfolie.

Die Metallfolie kann beispielsweise kommerziell erworben oder auf fachübliche Weise hergestellt werden. Die Kupferschichtoberseite der - zum Beispiel kommerziell erworbenen oder hergestellten - Metallfolie kann bereits die erforderliche oder bevorzugte Beschaffenheit im Hinblick auf den Gehalt an Sauerstoff und/oder Kohlenstoff aufweisen. Alternativ kann der Gehalt an Sauerstoff auf fachübliche Weise eingestellt werden.

Gemäß einer Ausführungsform kann zur Einstellung des Gehalts der Kupferschichtoberseite an Sauerstoff die Metallfolie einer kontrollierten Temperaturbehandlung und Konditionierung unterzogen werden. Hierzu kann die Metallfolie beispielsweise zunächst einer Temperatur im Bereich von 300 - 600°C, besonders bevorzugt bei einer Temperatur im Bereich von 350 - 550°C und ganz besonders bevorzugt bei einer Temperatur im Bereich von 400 - 500°C ausgesetzt werden. Die Aussetzung bei dieser Temperatur erfolgt vorzugsweise für einen Zeitraum von 30 min - 10 h, besonders bevorzugt für einen Zeitraum von 1 - 7 h und ganz besonders bevorzugt für einen Zeitraum von 2 - 5 h. Die Temperaturbehandlung erfolgt vorzugsweise in einer inerten oder reduzierenden Atmosphäre, zum Beispiel in einer Atmosphäre von Prozessgas (95% Stickstoff, 5% Wasserstoff). Sodann erfolgt vorzugsweise eine Abkühlung der Metallfolie, zum Beispiel auf Raumtemperatur. Nach der Temperaturbehandlung erfolgt vorzugweise eine Konditionierung, um die Ausbildung eines hohen Anteils von Kupferoxid und einer dicken Kupferoxidschicht zu vermeiden. Die Konditionierung erfolgt vorzugsweise unmittelbar nach der Abkühlung der Metallfolie. Hierzu wird die Metallfolie vorzugsweise in einer inerten Atmosphäre mit einem geringen Restfeuchtegehalt gelagert. Bei der inerten Atmosphäre kann es sich zum Beispiel um eine Stickstoffatmosphäre handeln. Der Restfeuchtegehalt kann vorzugsweise im Bereich von 0,2 - 1,0%, besonders bevorzugt im Bereich von 0,3 - 0,7% und ganz besonders bevorzugt im Bereich von 0,5 - 0,6% liegen. Die Lagerung erfolgt vorzugsweise für einen Zeitraum von 10 min - 100 h, besonders bevorzugt für einen Zeitraum von 30 min - 50 h und ganz besonders bevorzugt für einen Zeitraum von 10 - 40 h.

Gemäß einer anderen Ausführungsform kann die Einstellung des Gehalts der Kupferschichtoberseite an Sauerstoff auf eine alternative Weise erfolgen. Zum Beispiel kann die Kupferschichtoberseite auf eine geeignete Weise mit einem Oxidationsmittel behandelt werden. Alternativ dazu kann die Kupferschichtoberseite zunächst durch Temperaturbehandlung in einer oxidierenden Atmosphäre oder durch Behandlung mit einem Oxidationsmittel oberflächlich umfassend oxidiert werden, wobei anschließen die Behandlung mit einem Reduktionsmittel erfolgt, um die Kupferschichtoberseite auf den Zielwert für den Gehalt an Sauerstoff einzustellen. Ferner ist es möglich, die Kupferschichtoberseite zur Einstellung des Gehalts an Sauerstoff einer Plasmabehandlung zu unterziehen.

Zur Einstellung des Gehalts der Kupferschichtoberseite an Kohlenstoff kann die Kupferschichtoberseite zum Beispiel mit einer organischen Verbindung behandelt werden, mit der auch der Sauerstoffgehalt eingestellt werden kann (zum Beispiel Zitronensäure oder Benzotriazol).

In Schritt (B) des Verfahrens erfolgt die Bereitstellung eines Kontaktierungsmittels.

Bei dem Kontaktierungsmittel handelt es vorzugsweise um ein wie hierin an anderer Stelle beschriebenes Kontaktierungsmittel.

In Schritt (C) des Verfahrens erfolgt das Aufbringen des Kontaktierungsmittels auf der Metallfolienunterseite unter Ausbildung einer Kontaktierungsschicht.

Das Aufbringen des Kontaktierungsmaterials auf die Metallfolienunterseite unter Ausbildung einer Kontaktierungsschicht kann durch fachübliche Verfahren erfolgen. Vorzugsweise erfolgt das Aufbringen des Kontaktierungsmaterials durch Jetten, Dispensen, Sprühen, Pinseln, Tupfen, Tauchen oder Drucken, insbesondere Siebdrucken oder Schablonendrucken, oder durch Laminieren

Gemäß einer bevorzugten Ausführungsform erfolgt in einem weiteren Schritt (D) das Aufbringen eines Vorfixiermittels auf die Metallfolienunterseite und/oder die Kontaktierungsschicht unter Ausbildung einer Vorfixierschicht, wobei die Vorfixierschicht mit der Metallfolienunterseite und/oder der Kontaktierungsschicht wenigstens bereichsweise flächig verbunden ist. Bei dem Vorfixiermittel handelt es vorzugsweise um ein wie hierin an anderer Stelle beschriebenes Vorfixiermittel. Das Aufbringen des Vorfixiermittels auf die Metallfolienunterseite und/oder die Kontaktierungsschicht kann durch fachübliche Verfahren erfolgen. Vorzugsweise erfolgt das Aufbringen des Vorfixiermittels durch Jetten, Dispensen, Sprühen, Pinseln, Tupfen, Tauchen oder Drucken, insbesondere Siebdrucken oder Schablonendrucken.

Gemäß einer bevorzugten Ausführungsform erfolgt in einem weiteren Schritt (E) des Verfahrens eine Vortrocknung des Kontaktierungsmittels, besonders bevorzugt des Sintermaterials und ganz besonders bevorzugt der Sinterpaste. Die Vortrocknung kann dazu dienen, in dem Kontaktierungsmaterial enthaltene flüchtige Bestandteile, wie zum Beispiel organische Verbindungen, wenigstens teilweise zu entfernen. Das Vortrocknen kann zum Beispiel bei einer Temperatur im Bereich von 80 - 150°C und beispielsweise für einen Zeitraum von 2 - 30 Minuten erfolgen. Die Vortrocknung hat üblicherweise einen Volumenschwund zur Folge, so dass auch die Dicke der Kontaktierungsschicht reduziert wird.

Gemäß einer weiteren bevorzugten Ausführungsform erfolgt in einem weiteren Schritt (F) des Verfahrens eine Vortrocknung des Vorfixiermittels, so weit vorhanden. Die Vortrocknung kann dazu dienen, in dem Vorfixiermittel enthaltene flüchtige Bestandteile, wie zum Beispiel organische Verbindungen, wenigstens teilweise zu entfernen. Das Vortrocknen kann zum Beispiel bei einer Temperatur im Bereich von 80 - 150°C und beispielsweise für einen Zeitraum von 2 - 30 Minuten erfolgen. Die Vortrocknung hat üblicherweise einen Volumenschwund zur Folge, so dass auch die Dicke der Vorfixierschicht reduziert wird. Die Schritte (E) und (F) können auch zusammenfallen.

Bei dem Verfahren wird eine Substratanordnung mit einer Metallfolie erhalten, deren Oberseite mit einem Kupferbonddraht besonders stabil und mit gleichmäßig hoher Qualität verbunden werden kann.

Die Erfindung stellt ein Verfahren zur Herstellung einer elektronischen Baugruppe bereit.

Das Verfahren umfasst die folgenden Schritte:
(A) Bereitstellung eines Grundsubstrats, das eine Oberseite aufweist, wobei das Grundsubstrat eine Metallschicht umfasst,
(B) Bereitstellung eines Elektronikbauteils, das eine Oberseite und eine Unterseite aufweist,
(C) Bereitstellung einer hierin beschriebenen Substratanordnung,
(D) Kontaktierung der Oberseite des Grundsubstrats mit der Unterseite des Elektronikbauteils unter Ausbildung einer stoffschlüssigen Verbindung und
(E) Kontaktierung der Oberseite des Elektronikbauteils mit der Kontaktierungsschicht der Substratanordnung unter Ausbildung einer stoffschlüssigen Verbindung.

In Schritt (A) des Verfahrens wird ein Grundsubstrat bereitgestellt. Das Grundsubstrat umfasst eine Metallschicht. Ferner weist das Grundsubstrat eine Oberseite auf.

Die Metallschicht des Grundsubstrats kann zum Beispiel Kupfer oder Aluminium umfassen. Vorzugsweise kann die Metallschicht des Grundsubstrats aus einer Metallfolie gebildet sein. Gemäß einer bevorzugten Ausführung umfasst die Metallschicht des Grundsubstrats eine Kupferfolie.

Gemäß einer bevorzugten Ausführungsform besteht das Grundsubstrat aus der Metallschicht.

Gemäß einer anderen bevorzugten Ausführungsform umfasst das Grundsubstrat eine Metallschicht und eine Schicht aus isolierendem Material. Gemäß einer weiteren bevorzugten Ausführungsform umfasst das Grundsubstrat eine Metallschicht und eine Schicht aus isolierendem Material, die stoffschlüssig miteinander verbunden sind. Vorzugsweise umfasst das Grundsubstrat eine Schicht aus isolierendem Material, die auf einer ersten Seite und einer der ersten Seite abgewandten zweiten Seite stoffschlüssig mit einer Metallschicht verbunden ist. Das isolierende Material des Grundsubstrats ist vorzugsweise aus der Gruppe ausgewählt, die aus Glas und Keramik besteht. Die Keramik kann zum Beispiel aus der Gruppe ausgewählt sein, die aus Oxidkeramiken, Nitridkeramiken und Carbidkeramiken besteht.

Gemäß einer bevorzugten Ausführungsform ist das Grundsubstrat aus der Gruppe ausgewählt, die aus Metall-Keramik-Substraten, Printed Circuit Boards (PCBs) und Leadframes besteht. Gemäß einer besonders bevorzugten Ausführungsform handelt es sich bei dem Grundsubstrat um ein fachübliches Metall-Keramik-Substrat. Das Metall-Keramik-Substrat ist vorzugsweise aus der Gruppe ausgewählt, die aus DCB (Direct Copper Bonded)-Substraten und AMB (Active Metal Brazed)-Substraten besteht.

Die Oberseite des Grundsubstrats wird vorzugsweise durch die Metallschicht geschaffen.

In Schritt (B) des Verfahrens wird ein Elektronikbauteil bereitgestellt. Das Elektronikbauteil weist eine Oberseite und eine Unterseite auf.

Bei dem Elektronikbauteil handelt es vorzugsweise um ein wie hierin an anderer Stelle beschriebenes Elektronikbauteil.

In Schritt (C) des Verfahrens wird eine Substratanordnung bereitgestellt.

Bei der Substratanordnung handelt es sich vorzugsweise um eine wie hierin an anderer Stelle beschriebene Substratanordnung.

Die Substratanordnung weist daher vorzugsweise auf
(a) eine Metallfolie, die eine Metallfolienoberseite und eine Metallfolienunterseite umfasst, wobei die Metallfolie eine Kupferschicht umfasst, die eine Kupferschichtoberseite und eine Kupferschichtunterseite aufweist, wobei die Metallfolienoberseite von der Kupferschichtoberseite gebildet ist, und
(b) eine Kontaktierungsschicht, die auf der Metallfolienunterseite angeordnet ist,
wobei die Kupferschichtoberseite einen Gehalt an Sauerstoff im Bereich von 10 - 30 Atomprozent aufweist.

In Schritt (D) des Verfahrens wird die Oberseite des Grundsubstrats mit der Unterseite des Elektronikbauteils unter Ausbildung einer stoffschlüssigen Verbindung kontaktiert.

Das Grundsubstrat und das Elektronikbauteil werden hierzu vorzugsweise so positioniert, dass die Unterseite des Elektronikbauteils mit der Oberseite des Grundsubstrats vorzugsweise über ein Kontaktierungsmaterial in Kontakt steht. Bei dem Kontaktierungsmittel kann es sich beispielsweise um eine Sinterpaste, eine Lotpaste oder einen Leitkleber handeln. Der Aufbau umfassend das Grundsubstrat und das Elektronikbauteil wird anschließend einer Behandlung unterzogen, die eine stoffschlüssige Verbindung durch das Kontaktierungsmaterial erlaubt. Dabei wird die Unterseite des Elektronikbauteils auf der Oberseite des Grundsubstrats befestigt. Die Behandlung erfolgt vorzugsweise durch Einbringung von Energie. Die Einbringung von Energie kann vorzugsweise in Form von Temperaturbeaufschlagung und besonders bevorzugt in Form von Temperatur- und Druckbeaufschlagung erfolgen.

In Schritt (E) des Verfahrens wird die Oberseite des Elektronikbauteils mit der Kontaktierungsschicht der Substratanordnung unter Ausbildung einer stoffschlüssigen Verbindung kontaktiert. Dabei erfolgt vorzugsweise die Ausbildung einer stoffschlüssigen Verbindung zwischen der Oberseite des Elektronikbauteils und der Metallfolie der Substratanordnung.

Die Substratanordnung und das Elektronikbauteil werden hierzu vorzugsweise so positioniert, dass die Kontaktierungsschicht der Substratanordnung mit der Oberseite des Elektronikbauteils in Kontakt steht. Der Aufbau umfassend die Substratanordnung und das Elektronikbauteil wird anschließend einer Behandlung unterzogen, die eine stoffschlüssige Verbindung durch die Kontaktierungsschicht erlaubt. Dabei wird die Metallfolie der Substratanordnung auf der Oberseite des Elektronikbauteils befestigt. Die Behandlung erfolgt vorzugsweise durch Einbringung von Energie. Die Einbringung von Energie kann vorzugsweise in Form von Temperaturbeaufschlagung und besonders bevorzugt in Form von Temperatur- und Druckbeaufschlagung erfolgen.

Die Schritte (D) und (E) können in einem Fertigungsschritt oder in unterschiedlichen Fertigungsschritten durchgeführt werden. Dabei können die Schritte (D) und (E) sequenziell oder gleichzeitig durchgeführt werden.

Sofern die Schritte (D) und (E) sequenziell durchgeführt werden, kann Schritt (D) zeitlich vor Schritt (E) erfolgen. Andererseits ist es auch möglich, dass Schritt (E) vor Schritt (D) erfolgt.

Sofern die Schritte (D) und (E) sequenziell durchgeführt werden, kann gemäß einer ersten Ausführungsform in Schritt (D) das Elektronikbauteil Teil einer ersten Anordnung sein, die das Elektronikbauteil und die Metallfolie der Substratanordnung umfasst. In diesem Fall kann zunächst in Schritt (E) eine erste Anordnung, die das Elektronikbauteil und die Metallfolie der Substratanordnung umfasst, hergestellt werden, indem die Oberseite des Elektronikbauteils mit der Metallfolie der Substratanordnung unter Ausbildung einer stoffschlüssigen Verbindung zwischen der Oberseite des Elektronikbauteils und der Metallfolie der Substratanordnung kontaktiert wird. Diese erste Anordnung kann anschließend in Schritt (D) mit dem Grundsubstrat kontaktiert werden, so dass die Unterseite des Elektronikbauteils als Teil der ersten Anordnung mit der Oberseite des Grundsubstrats stoffschlüssig verbunden wird.

Sofern die Schritte (D) und (E) sequenziell durchgeführt werden, kann gemäß einer zweiten Ausführungsform in Schritt (E) das Elektronikbauteil Teil einer zweiten Anordnung sein, die das Grundsubstrat und das Elektronikbauteil umfasst. In diesem Fall kann zunächst in Schritt (D) eine zweite Anordnung, die das Grundsubstrat und das Elektronikbauteil umfasst, hergestellt werden. Diese zweite Anordnung kann anschließend in Schritt (E) mit der Substratanordnung kontaktiert werden, so dass die Metallfolie der Substratanordnung mit der Oberseite des Elektronikbauteils als Teil der zweiten Anordnung stoffschlüssig verbunden wird.

Durch die stoffschlüssige Verbindung von Grundsubstrat, Elektronikbauteil und Metallfolie der Substratanordnung wird eine elektronische Baugruppe erhalten.

Gemäß einer bevorzugten Ausführungsform erfolgt in einem weiteren Schritt (F) die elektrische Kontaktierung eines Bereichs auf der Oberseite der Metallfolie mit einem Bereich auf der Oberseite des Grundsubstrats. Die elektrische Kontaktierung erfolgt vorzugsweise durch Drahtbonden. Für das Drahtbonden wird vorzugsweise ein Bonddraht verwendet. Der Begriff Bonddraht umfasst zum Bonden geeignete Drähte vorzugsweise unabhängig von deren Durchmesser beziehungsweise Dicke und besonders bevorzugt unabhängig von deren Querschnittsgeometrie (so zum Beispiel auch Bondbänder). Der Bonddraht umfasst vorzugsweise Kupfer. Gemäß einer bevorzugten Ausführungsform ist der Bonddraht aus einem Material beschaffen, das aus der Gruppe ausgewählt ist, die aus Kupfer und Kupferlegierungen besteht.

### Figurenbeschreibung:

Weitere Merkmale und Vorteile der Erfindung ergeben sich aus der nachfolgenden Figurenbeschreibung, in der bevorzugte Ausführungsformen der Erfindung anhand von schematischen Zeichnungen erläutert sind.

### Dabei zeigen:

- Figur 1: die Seitenansicht einer erfindungsgemäßen Substratanordnung und
- Figur 2: die Seitenansicht einer elektronischen Baugruppe, die unter Verwendung der erfindungsgemäßen Substratanordnung erhalten wird.

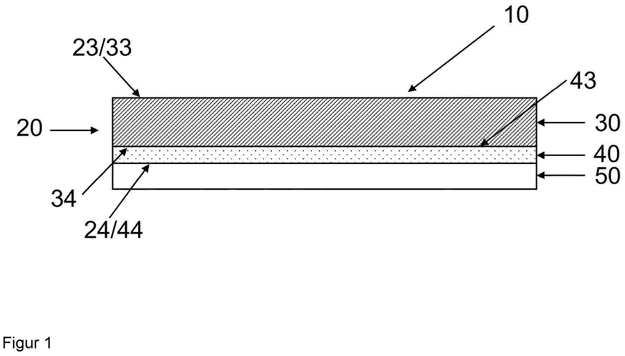

Figur 1 zeigt - nicht maßstabsgetreu - eine erfindungsgemäße Substratanordnung 10, die eine Metallfolie 20 und eine Kontaktierungsschicht 50 umfasst. Die Metallfolie 20 umfasst eine Metallfolienoberseite 23 und eine Metallfolienunterseite 24 Die Metallfolie 20 ist aus einer Kupferschicht 30 und einer Haftvermittlungsschicht 40 gebildet. Die Kupferschicht 30 weist eine Kupferschichtoberseite 33 und eine Kupferschichtunterseite 34 auf. Die Kupferschichtoberseite 33 weist einen Gehalt an Sauerstoff im Bereich von 10 - 30 Atomprozent auf Die Haftvermittlungsschicht 40 weist eine Haftvermittlungsschichtoberseite 43 und eine Haftvermittlungsschichtunterseite 44 auf. Die Haftvermittlungsschichtoberseite 43 ist mit der Kupferschichtunterseite 34 stoffschlüssig verbunden. Die Metallfolienoberseite 23 ist von der Kupferschichtoberseite 33 gebildet. Die Metallfolienunterseite 24 ist von der Haftvermittlungsschichtunterseite 44 gebildet. Die Kontaktierungsschicht 50 ist auf der Metallfolienunterseite 24 beziehungsweise der Haftvermittlungsschichtunterseite 44 angeordnet.

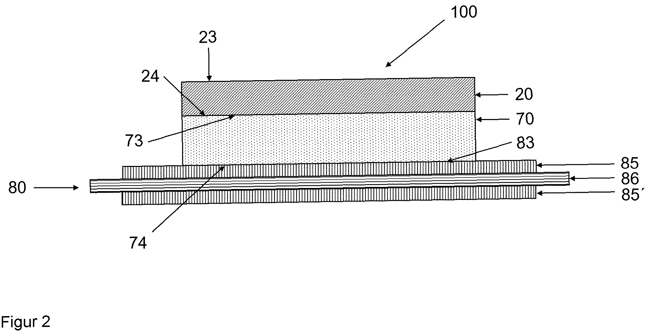

Figur 2 zeigt eine elektronische Baugruppe 100, die durch das erfindungsgemäße Verfahren hergestellt werden kann. Die elektronische Baugruppe 100 umfasst eine Metallfolie 20, ein Elektronikbauteil 70 und ein Grundsubstrat 80. Das Grundsubstrat 80 weist eine Schicht aus isolierendem Material 86 auf, die beidseitig mit einer Metallschicht 86, 86' flächig verbunden ist. Bei dem Grundsubstrat 80 handelt es sich typischerweise um ein Metall-Keramik-Substrat. Die Oberseite 83 des Grundsubstrats 80 wird durch die Metallschicht 85 geschaffen. Auf der Oberseite 83 des Grundsubstrats 80 ist ein Elektronikbauteil 70 angeordnet, das eine Oberseite 73 und eine Unterseite 74 aufweist. Die Unterseite 74 des Elektronikbauteils 70 ist auf der Oberseite 83 des Grundsubstrats 80 angeordnet. Das Elektronikbauteil 70 ist mit dem Grundsubstrat 80 flächig verbunden. Hierzu kann das Elektronikbauteil 70 zum Beispiel unter Verwendung einer Sinterpaste auf dem Grundsubstrat 80 befestigt sein. Zwischen der Oberseite 83 des Grundsubstrats 80 und der Unterseite 74 des Elektronikbauteils 70 kann sich daher eine Verbindungszone befinden (nicht gezeigt). Das Elektronikbauteil 70 ist mit einer Metallfolie 20 über eine Verbindungszone (nicht gezeigt) verbunden. Die Metallfolie 20 weist eine Metallfolienoberseite 23 und eine Metallfolienunterseite 24 auf. Die Metallfolienunterseite 24 ist auf der Oberseite 73 des Elektronikbauteils 40 angeordnet. Die Metallfolie 20 ist auf dem Elektronikbauteil 70 befestigt. Die Befestigung kann erfolgen, indem zunächst eine Substratanordnung (wie in Figur 1 gezeigt), die die Metallfolie 20 und eine Kontaktierungsschicht umfasst, auf der Oberseite 73 des Elektronikbauteils 70 so positioniert wird, dass die Kontaktierungsschicht mit der Oberseite 73 des Elektronikbauteils 70 in Kontakt steht. Anschließend wird der so erhaltene Aufbau Bedingungen ausgesetzt, die die Ausbildung einer stoffschlüssigen Verbindung zwischen der Metallfolie 20 und dem Elektronikbauteil 70 ermöglichen. Die Kontaktierungsschicht kann beispielsweise aus einer vorgetrockneten Sinterpaste bestehen. In diesem Fall wird der Aufbau zum Beispiel mit Temperatur und Druck beaufschlagt, um die Ausbildung einer Sinterverbindung zwischen der Metallfolie 20 und dem Elektronikbauteil 70 zu ermöglichen. Bei der Ausbildung der Sinterverbindung wird zwischen der Metallfolie 20 und dem Elektronikbauteil 70 durch die Kontaktierungsschicht eine Verbindungszone geschaffen (nicht gezeigt). Die Metallfolienoberseite kann mit unbestückten Bereichen auf der Oberseite 83 des Grundsubstrats 80 mit einem Bonddraht kontaktiert werden (nicht gezeigt). Die Metallfolienoberseite kann außerdem mit einer weiteren Komponente, insbesondere unter Verwendung eines Sintermaterials, stoffschlüssig verbunden werden (nicht gezeigt).

### Beispiele:

Die vorliegende Erfindung wird nachstehend anhand von Beispielen veranschaulicht, die jedoch nicht als einschränkend zu verstehen sind.

### 1. Herstellung von Substratanordnungen

Zur Herstellung einer Substratanordnung gemäß den Beispielen und den Vergleichsbeispielen wurden Kupferfolien mit einer Dicke von 50 µm verwendet. Diese Kupferfolien wurden mittels fotolithografischem Ätzen unter Verwendung einer geeigneten Maskierung mit einer Eisenchlorid (FeCl₃)-Ätzlösung in Kupferfolienstücke der Abmaße 7,6 mm x 7,6 mm strukturiert, wobei die einzelnen Kupferfolienstücke noch über Stege miteinander verbunden waren. Die Maskierung wurde anschließend entfernt.

### Beispiel 1:

Die Kupferfolienstücke wurden im Batchofen bei einer Temperatur von 450°C wärmebehandelt. Hierzu wurde die Glühkammer nach dem Einbringen der Kupferfolienstücke zunächst mit Prozessgas (Gemisch aus 5 % Wasserstoff und 95 % Stickstoff) gespült. Diese Prozessgasbehandlung erfolgte für eine Dauer von 30 min bei einem Gasfluss von 16 I / min (Restsauerstoffgehalt ≤ 0,2%). Anschließend wurde der Ofen mit einer Heizrate von 1 °C/min aufgeheizt, bis eine Temperatur von 450°C erreicht war. Nach 3 h Behandlungsdauer wurde der Ofen ausgeschaltet und abkühlen gelassen. Nach dem Erreichen von Raumtemperatur wurde der Gasfluss gestoppt und die Kupferfolienstücke wurden entnommen. Diese wurden nun einem Konditionierungsschritt unterzogen. Hierzu wurden die Kupferfolienstücke in einem Trockenschrank bei einer Temperatur von 25 °C in einer Stickstoffatmosphäre bei einer Restfeuchte von 0,5 - 0,6 % für einen Zeitraum von 24 h gelagert.

Die Kupferfolienstücke wurden sodann auf eine Transferfolie (Chip-Sägefolie) in einem Kunststoffrahmen aufgebracht und mit einer 400 nm dicken galvanischen Silberschicht metallisiert. Anschließend wurde auf diese Silberschicht eine Silbersinterschicht aufgebracht. Hierzu wurde auf einen Bereich von 7,1 mm x 7,1 mm eine Sinterpaste (ASP 043-60, Heraeus) mittels Schablonendrucks aufgebracht (Nassschichtdicke = 40 µm). Außer dem mit Sinterpaste versehenen Bereich wies die Beschichtung einen umlaufenden, von Sinterpaste freien Randbereich von 0,25 mm Breite auf. Die so mit einer Sinterpaste auf der Beschichtung versehenen Kupferfolienstücke wurden anschließend an Luftatmosphäre für zehn Minuten bei 110°C getrocknet, vom Rahmen entfernt, von der Transferfolie gelöst und unter Trennung der Stege mittels Laser vereinzelt, wobei Substratanordnungen erhalten wurden, die eine Metallfolie umfassend eine Metallfolienoberseite und eine Metallfolienunterseite, sowie eine Kontaktierungsschicht aufwiesen, wobei die Kontaktierungsschicht auf der Metallfolienunterseite angeordnet war.

### Beispiel 2:

Beispiel 2 wurde analog zu Beispiel 1 durchgeführt, wobei die Kupferfolienstücke im Konditionierungsschritt in einem Trockenschrank bei einer Temperatur von 25 °C in einer Stickstoffatmosphäre bei einer Restfeuchte von 0,5 - 0,6 % für einen Zeitraum von 20 h gelagert wurden. Die Kupferfolienstücke wurden direkt weiterprozessiert.

### Beispiel 3:

Beispiel 3 wurde analog zu Beispiel 1 durchgeführt, wobei die Kupferfolienstücke im Konditionierungsschritt in einem Trockenschrank bei einer Temperatur von 25 °C in einer Stickstoffatmosphäre bei einer Restfeuchte von 0,5 - 0,6 % für einen Zeitraum von 15 h gelagert wurden. Die Kupferfolienstücke wurden direkt weiterprozessiert.

### Beispiel 4:

Beispiel 4 wurde analog zu Beispiel 1 durchgeführt, wobei die Kupferfolienstücke im Konditionierungsschritt in einem Trockenschrank bei einer Temperatur von 25 °C in einer Stickstoffatmosphäre bei einer Restfeuchte von 0,5 - 0,6 % für einen Zeitraum von 10 h gelagert wurden. Die Kupferfolienstücke wurden direkt weiterprozessiert.

### Beispiel 5:

Beispiel 5 wurde analog zu Beispiel 1 durchgeführt, wobei die Kupferfolienstücke im Konditionierungsschritt in einem Trockenschrank bei einer Temperatur von 25 °C in einer Stickstoffatmosphäre bei einer Restfeuchte von 0,5 - 0,6 % für einen Zeitraum von 30 min gelagert wurden. Die Kupferfolienstücke wurden direkt weiterprozessiert.

### Vergleichsbeispiel 1:

Vergleichsbeispiel 1 wurde analog zu Beispiel 1 durchgeführt, wobei jedoch kein Konditionierungsschritt durchgeführt wurde. Die Kupferfolienstücke wurden direkt weiterprozessiert.

### Vergleichsbeispiel 2:

Vergleichsbeispiel 2 wurde analog zu Beispiel 1 durchgeführt, wobei jedoch kein Konditionierungsschritt durchgeführt wurde und die Folienstücke vor dem Weiterprozessieren für 96 Stunden bei Raumtemperatur (24°C) unter Standardatmosphäre (Luft) gelagert wurden.

### 2. Herstellung von elektronischen Baugruppen

Zur Herstellung von elektronischen Baugruppen wurden zunächst Anordnungen aus je einem Grundsubstrat und je einem Elektronikbauteil geschaffen. Als Grundsubstrat wurde ein kommerziell erhältliches direktmetallisiertes Kupfer-Keramik-Substrat (DCB; Condura^{®} classic, Heraeus) und als Elektronikbauteil ein Siliziumchip mit der Abmessung 8,8 mm x 8,8 mm (Dicke = 70 µm), der eine unterseitige Metallisierung (NiP/Pd) sowie eine oberseitige Metallisierung (NiP/Pd) aufwies, verwendet.

Auf die Oberseite der Kupfer-Keramik-Substrate wurde eine Sinterpaste (ASP 338-28, Heraeus) mittels Schablonendrucks aufgebracht (Nassschichtdicke = 100 µm). Die mit Sinterpaste versehenen Kupfer-Keramik-Substrate wurden an Luftatmosphäre für zehn Minuten bei 100°C getrocknet und anschließend abgekühlt. Auf den vorgetrockneten Sinterpasten wurde je ein Siliziumchip positioniert, so dass die Unterseite der Siliziumchips mit der Oberseite des jeweiligen Kupfer-Keramik-Substrats in Kontakt stand.

Anschließend wurden die jeweiligen Substratanordnungen gemäß den Beispielen 1 bis 5 sowie den Vergleichsbeispielen 1 und 2 jeweils auf der Oberseite eines Siliziumchips positioniert, so dass die Silbersinterschicht der jeweiligen Substratanordnung mit der Oberseite des Siliziumchips in Kontakt stand.

Sodann wurde der jeweilig erhaltene Aufbau gesintert. Das Sintern erfolgte in einer Sinterpresse (Fa. Pink, Wertheim) für eine Dauer von drei Minuten in einer Stickstoffatmosphäre bei einem Druck von 20 MPa und einer Temperatur von 250°C. Dabei wurden elektronische Baugruppen erhalten, die jeweils mit Metallfolien aus den Substratanordnungen gemäß den Beispielen 1 bis 5 bzw. mit Metallfolien aus den Substratanordnungen gemäß den Vergleichsbeispielen 1 und 2 ausgestattet waren.

Anschließend erfolgte das Bonden eines Kupferbonddrahtes mit einem Durchmesser von 400 µm (Power Cu Soft, Heraeus) auf die Oberseite der Metallfolie der hergestellten elektronischen Baugruppen. Hierzu wurde der Kupferbonddraht in einem Wedge-Wedge-Bondverfahren mit einem Wedge-Bonder (Asterion Orthodyne Bonder, Kulicke & Soffa) bei einer Frequenz von 80 kHz auf die Oberseite der Metallfolie der elektronischen Baugruppe gebondet.

### 3. Auswertung

### 3.1 Bestimmung des Sauerstoff- und Kohlenstoffgehalts an der Kupferschichtoberseite der Substratanordnungen (ohne und mit Absputtern)

An den Metallfolien der mit den Substratanordnungen der Beispiele 1 - 5 und der Vergleichsbeispiele 1 und 2 hergestellten elektronischen Baugruppen wurde der Sauerstoffgehalt und der Kohlenstoffgehalt an der Kupferschichtoberseite mittels Auger-Elektronenspektroskopie bestimmt.

Die Messung erfolgte mit dem PHI 5800 MultiTechnique ESCA System (Physical Electronics, Inc., USA). Die zu vermessenden Substratanordnungen wurden nach zweimaligem Spülen mit Stickstoff mit einer Reinheit von 4 N in die Messkammer des PHI 5800 MultiTechnique ESCA System eingebracht. In der Messkammer erfolgte die Messung des Gehalts der Kupferschichtoberseite an Kupfer und Sauerstoff mittels Auger-Elektronenspektroskopie. Für die Tiefenprofilmessungen wurde ebenfalls das PHI 5800 MultiTechnique ESCA System verwendet. Hierzu wurde die Kupferschichtoberseite der Probe für 180 s beziehungsweise 300 s besputtert und der Gehalt der Kupferschichtoberseite an Kupfer und Sauerstoff mittels Auger-Elektronenspektroskopie gemessen. Das Sputtern erfolgte mit einer Ionen-Kanone (mit Xenon-Ionen als lonenquelle), die mit einer Beschleunigungsspannung von 4 kV bei einer Sputterrate von 1,0 nm/min gegen die Referenz Tantalpentoxid betrieben wurde. Die Analyseparameter für die Auger-Elektronenspektroskopie waren 5 kV bei einem Strahlstrom von 15 nA und einem Messfleck von 100 x100 µm. Die Auswertung der mittels Auger-Elektronenspektroskopie erhaltenen Signale erfolgte mit der Software: PHI MultiPak Version 9.9 (Physical Electronics, Inc., USA). Die Bestimmung erfolgte jeweils an fünf unterschiedlichen Bereichen der Substratanordnung. Die jeweiligen Mittelwerte der fünf Messungen sind in Tabelle 1 angeben.

### 3.2 Bewertung der Bondergebnisse

Die Metallfolien der mit den Substratanordnungen der Beispiele 1 - 5 und der Vergleichsbeispiele 1 und 2 hergestellten elektronischen Baugruppen wurden daraufhin untersucht, ob die Oberseite der Metallfolie mit einem Kupferbonddraht besonders stabil und mit gleichmäßig hoher Qualität verbindbar ist. Zu diesem Zweck wurden die mit den Substratanordnungen der Beispiele 1 - 5 und der Vergleichsbeispiele 1 und 2 hergestellten und mit einem Bonddraht versehenen elektronischen Baugruppen einer mechanischen Pulltestprüfung gemäß dem DVS-Merkblatt 2811 (Deutscher Verband für Schweißen und verwandte Verfahren e. V.) unterzogen. Bei der Pulltestprüfung wurde die Verbindung des Bonddrahtes mit der Metallfolienoberseite der elektronischen Baugruppe untersucht. Die Pulltestprüfung erfolgte mit einem XYTEC Condor Sigma Pulltester (xyztec bv), der mit einer Kraftmessdose (10 kg) und einem Pullhaken (1200 µm) ausgerüstet war. Die Bewertung der Bondergebnisse erfolgt in Anlehnung an das DVS-Merkblatt 2811 (Deutscher Verband für Schweißen und verwandte Verfahren e. V.) wie folgt:

| | |
|---|---|
| "--": | Bond hält nicht auf der Kupferoberfläche (sogenannter "Wedge Lift Off"). |
| "-": | Drahtbruch im Bereich des Übergangs von Bondverbindung zum Drahtbereich (sogenannter "Heel-Bruch") mit stark reduzierter Pulllkraft (< 10 N). |
| .+": | Drahtbruch im Bereich des Übergangs von Bondverbindung zum Drahtbereich (sogenannter Heel Bruch) mit leicht reduzierter Pullkraft (10 - 15 N). |
| .++": | Drahtbruch mit hoher Pullkraft (> 20N). |

Die Ergebnisse sind in Tabelle 1 dargestellt.

**Tabelle 1: Ergebnisse der Untersuchung der Substratanordnungen der Beispiele 1 - 5 und der Vergleichsbeispiele 1 und 2.**

| | **Gehalt der Elemente in At.% (O: Sauerstoff, C: Kohlenstoff)** | | | | | | **Bondergebnis** |
|---|---|---|---|---|---|---|---|
| **Sputtern** | **-** | **-** | **180 s** | **180 s** | **300 s** | **300 s** | |
| | **O** | **C** | **O** | **C** | **O** | **C** | |
| Beispiel 1 | 15 | 40 | <1 | <1 | <1 | <1 | ++ |
| Beispiel 2 | 17 | 45 | <1 | <1 | < 1 | <1 | ++ |
| Beispiel 3 | 20 | 41 | <1 | <1 | <1 | <1 | ++ |
| Beispiel 4 | 23 | 38 | 1 | <1 | <1 | <1 | ++ |
| Beispiel 5 | 27 | 30 | 10 | <1 | <1 | <1 | + |
| Vergleichsbeispiel 1 | 32 | 39 | 15 | 3 | 5 | <1 | Überwiegend .--", lokal stark schwankend |
| Vergleichsbeispiel 2 | 35 | 28 | 15 | <1 | 10 | <1 | Überwiegend .--", lokal stark schwankend |

### 3.3 Beurteilung

Die Ergebnisse zeigen, dass mit den erfindungsgemäßen Substratanordnungen der Beispiele 1 - 5 eine besonders stabile Verbindung eines Kupferbonddrahtes mit der Oberseite der Metallfolie der Substratanordnungen erreicht werden kann. Diese Verbindung ist stabiler und von gleichmäßigerer Qualität als eine Verbindung, die mit den Substratanordnungen der Vergleichsbeispiele 1 und 2 erhalten wird. Insbesondere weist die Oberseite der Metallfolie eine homogene Beschaffenheit auf, die die Ausbildung einer stabilen Bondverbindung mit gleichmäßig hoher Qualität ermöglicht.

### Bezugszeichenliste:

- 10: Substratanordnung
- 20: Metallfolie
- 23: Metallfolienoberseite
- 24: Metallfolienunterseite
- 30: Kupferschicht
- 33: Kupferschichtoberseite
- 34: Kupferschichtunterseite
- 40: Haftvermittlungsschicht
- 43: Haftvermittlungsschichtoberseite
- 44: Haftvermittlungsschichtunterseite
- 50: Kontaktierungsschicht
- 70: Elektronikbauteil
- 73: Oberseite (Elektronikbauteil)
- 74: Unterseite (Elektronikbauteil)
- 80: Grundsubstrat
- 83: Oberseite (Grundsubstrat)
- 85, 85': Metallschicht
- 86: Schicht aus isolierendem Material
- 100: Elektronische Baugruppe

## Patentansprüche

1. Substratanordnung aufweisend
(a) eine Metallfolie, die eine Metallfolienoberseite und eine Metallfolienunterseite umfasst, wobei die Metallfolie eine Kupferschicht umfasst, die eine Kupferschichtoberseite und eine Kupferschichtunterseite aufweist, wobei die Metallfolienoberseite von der Kupferschichtoberseite gebildet ist, und
(b) eine Kontaktierungsschicht, die auf der Metallfolienunterseite angeordnet ist,
**dadurch gekennzeichnet, dass** die Kupferschichtoberseite einen Gehalt an Sauerstoff im Bereich von 10 - 30 Atomprozent aufweist.

2. Substratanordnung nach Anspruch 1, **dadurch gekennzeichnet, dass** die Kupferschichtoberseite einen Gehalt an Kohlenstoff im Bereich von 30 - 60 Atomprozent aufweist.

3. Substratanordnung nach Anspruch 1 oder 2, **dadurch gekennzeichnet, dass** die Kupferschichtoberseite so beschaffen ist, dass bei einer Tiefenprofilmessung nach Absputtern für eine Sputterzeit von 300 s (Sputterrate: 1,0 nm/min für Referenz Tantalpentoxid; lonenquelle: Xenon-Ionen, Beschleunigungsspannung: 4 kV) die freigelegte Kupferschichtoberseite einen Gehalt an Sauerstoff von weniger als 1,0 Atomprozent aufweist.

4. Substratanordnung nach einem der vorangegangenen Ansprüche, **dadurch gekennzeichnet, dass** die Metallfolie eine Haftvermittlungsschicht umfasst, die eine Haftvermittlungsschichtoberseite und eine Haftvermittlungsschichtunterseite aufweist, wobei die Haftvermittlungsschichtoberseite mit der Kupferschichtunterseite stoffschlüssig verbunden ist.

5. Substratanordnung nach Anspruch 4, **dadurch gekennzeichnet, dass** die Haftvermittlungsschicht mehrlagig ausgestaltet ist.

6. Substratanordnung nach einem der vorangegangenen Ansprüche, **dadurch gekennzeichnet, dass** die Kontaktierungsschicht ein Kontaktierungsmittel umfasst.

7. Substratanordnung nach Anspruch 6, **dadurch gekennzeichnet, dass** das Kontaktierungsmittel wenigstens ein Mitglied umfasst, das aus der Gruppe ausgewählt ist, die aus Silber und Kupfer besteht.

8. Substratanordnung nach Anspruch 6 oder 7, **dadurch gekennzeichnet, dass** das Kontaktierungsmittel ein Sintermaterial umfasst.

9. Substratanordnung nach Anspruch 8, **dadurch gekennzeichnet, dass** die Kontaktierungsschicht eine vorgetrocknete Sinterpaste umfasst.

10. Verfahren zur Herstellung einer elektronischen Baugruppe umfassend die Schritte
(A) Bereitstellung eines Grundsubstrats, das eine Oberseite aufweist, wobei das Grundsubstrat eine Metallschicht umfasst,
(B) Bereitstellung eines Elektronikbauteils, das eine Oberseite und eine Unterseite aufweist, und
(C) Bereitstellung einer Substratanordnung gemäß einem der vorangegangenen Ansprüche,
(D) Kontaktierung der Oberseite des Grundsubstrats mit der Unterseite des Elektronikbauteils unter Ausbildung einer stoffschlüssigen Verbindung und
(E) Kontaktierung der Oberseite des Elektronikbauteils mit der Kontaktierungsschicht der Substratanordnung unter Ausbildung einer stoffschlüssigen Verbindung.

11. Elektronische Baugruppe herstellbar durch ein Verfahren gemäß Anspruch 10.
